# EUROPEAN PATENT APPLICATION

(11) **EP 4 852 627 A1**
(43) Date of publication of application: **09.12.2026**
(21) Application number: 25180217.9
(22) Date of filing: 02.06.2025
(51) Int. Cl.: H05K 5/00, H05K 5/06

(54) **ELECTRONIC CONTROL DEVICE FOR A MOTOR VEHICLE AND MOTOR VEHICLE**

(71) Applicant: Connaught Electronics Ltd., County Galway H54 Y276 (IE)
(72) Inventor: VENKATGOWDA, Pruthviraj, Dublin 1, D01 R8H7 (IE); SINGARAM, Saravanan, 600130 Chennai, Tamil Nadu (IN); CLEARY, Brian, Tuam, H54 Y276 (IE); THIRUMALAI, Gunasekaran, 600130 Chennai, Tamil Nadu (IN)
(74) Representative: Jauregui Urbahn, Kristian

(57) **Abstract**

The invention is directed at an electronic control device (10) for a motor vehicle (40), comprising at least one electronic component and a housing (12), wherein the electronic component is arranged inside the housing (12), wherein connecting interfaces (20) for connecting the at least one electronic component to a vehicle electronic network are arranged along a side of the housing (12), which faces an environment of the housing (12). A cover (22) is arranged on an outside surface (16) of the housing (12), wherein in an assembled state, the cover (22) at least partially covers at least the side of the housing (12), which comprises the connecting interfaces (20) for connecting the at least one electronic component to the vehicle electronic network, while maintaining the accessibility of the connecting interfaces (20).

## Description

The invention is directed at an electronic control device for a motor vehicle, comprising at least one electronic component and a housing, wherein the electronic component is arranged inside the housing, wherein connecting interfaces for connecting the at least one electronic component to a vehicle electronic network are arranged along a side of the housing, which faces an environment of the housing. In other words, the at least one electronic component can be electrically connected to the vehicle electronic network through the housing via the connecting interfaces. The connecting interfaces can be electrically connected to the at least one electronic component inside the housing on one hand and to the vehicle electronic network outside the housing on the other hand. A further aspect of the invention is directed at a motor vehicle with such an electronic control device.

The functionality and computing power of computing systems for vehicles increases as more and more sophisticated applications are installed in the vehicles, for example applications for driver assistance systems or other semi-automatic or fully automatic driving functions. In particular, modern vehicles are equipped with a range of electronic control devices such as electronic control units (ECUs), domain control units (DCUs) or zone control units (ZPUs). Typically, such an electronic control device comprises one or more electronic components, which are arranged inside a housing of the electronic control device. The electronic component(s) may be connected to a vehicle electronic network or an on-board network of the vehicle via one or more connecting interfaces. The connecting interfaces typically are arranged on one side of the housing and provide sockets or the like for electrically connecting the electronic component(s) to the vehicle electronic network.

In the design of electronic control devices (ECU Design), one of the challenging and mandatory parts is to pass the so-called water drip test (IP testing or Ingress Protection testing), which validates the prevention of water entry in the housing of the ECU assembly in the mounting condition in the motor vehicle. Often, the mounting condition or orientation of the electronic control device in the motor vehicle can be chosen such that water entry into the housing of the electronic control device driven by gravity can be avoided. In other words, the housing of the electronic control device may be mounted in an orientation, which prevents gravitational water entry into the housing.

However, depending on available assembly space inside the motor vehicle, such an orientation of the housing is not always possible. This may lead to situations, where the housing needs to be redesigned completely, which leads to increased production costs for the housing and more and more complex designs. In some cases, connecting interfaces should be visible in the mounted state of the housing in the motor vehicle, which poses an additional problem.

It is an object of the present invention to provide an electronic control device for a motor vehicle with a housing, which prevents water entry into the housing, while providing maximum flexibility as regards mounting orientation of the housing in the motor vehicle.

The object is solved by the subject matters of the independent patent claims. Advantageous further embodiments of the invention are described by the dependent patent claims, the following description and the figures.

The invention is based on the realization, that a cover can be added to an ECU assembly, which fully restricts water entry at any mounting angle.

The invention is directed at an electronic control device for a motor vehicle, comprising at least one electronic component and a housing, wherein the electronic component is arranged inside the housing, wherein connecting interfaces for connecting the at least one electronic component to a vehicle electronic network are arranged along a side of the housing, which faces an environment of the housing. In other words, the at least one electronic component can be electrically connected to the vehicle electronic network through the housing via the connecting interfaces. The connecting interfaces can be electrically connected to the at least one electronic component inside the housing on one hand and to the vehicle electronic network outside the housing on the other hand.

According to the invention, a cover is arranged on an outside surface of the housing, wherein in an assembled state of the electronic control device, the cover at least partially covers or overlaps at least the side of the housing, which comprises the connecting interfaces for connecting the at least one electronic component to the vehicle electronic network. The connecting interfaces themselves, however, remain accessible. This is ensured by designing the cover such that it does not cover the side of the housing, which comprises the connecting interfaces, completely and/or permanently. The connecting interfaces preferably remain uncovered from the front, i.e. from the side of the housing, which contains the connecting interfaces. At the same time, the connecting interfaces may be covered from the top side of the housing, wherein the top side of the housing may be oriented perpendicularly with respect to the front, i.e. to the side of the housing, which comprises the connecting interfaces. The terms "top" and "front" refer to a predetermined mounting state of the electronic component with the cover inside the motor vehicle.

In other words, according to the invention, the housing is equipped with an extra cover, which is placed over the connecting interfaces on an outside surface of the housing, covering the connecting interfaces from the top, such that water entry into the housing of the electronic control device from any possible mounting direction is prevented, while the connecting interfaces remain accessible from the front. The electronic control device equipped with the cover can be mounted in a wide variety of angles within the vehicle body, for example from - 90 to + 90 degrees, measured from a vertical axis, for example from the y-axis of the vehicle. The cover can be designed as a separate part and assembled over an upper housing part, ensuring water entry prevention and protecting the connecting interfaces.

Further embodiments of the invention provide additional advantages.

According to an embodiment, the cover is at least partially made from a transparent material, preferably a transparent plastic material. This addresses the need for visibility of the connecting interfaces. In addition, the plastic material can be brought into any shape very easily, it is light-weight and comparably cheap. In particular, the plastic material can be formed according to an outer shape of the housing or at least of the side of the housing, which comprises the connecting interfaces. Like this, the cover can be adapted to snugly fit to an outer contour of the housing, which is advantageous in that the cover does not need much additional assembly space in the vehicle.

In particular, the cover may be formed with a roof portion, which extends away from the side of the housing with the connecting interfaces. Like this, the connecting interfaces are not obstructed by the cover, yet they are reliably protected from any contamination from outside the housing.

According to a further embodiment, the cover comprises a bending portion, wherein the bending portion connects a base plate of the cover to a rim portion of the cover.

Preferably, the base plate of the cover at least partially covers the top portion of the electronic component housing and the rim portion of the cover at least partially overlaps or covers side portions of the electronic component housing, while leaving free or accessible the connecting interfaces.

According to a further embodiment, the cover comprises as bending portion a hinge, wherein a portion of the cover is designed to be lifted from the outside surface of the housing, thereby bending the cover along the hinge. The hinge can be formed as a folding hinge. By lifting parts of the cover, easy accessibility of the connecting interfaces can be ensured.

Preferably, the portion designed to be lifted from the outside surface of the housing at least partially covers the connecting interfaces.

According to a further embodiment, the shape of the cover is adapted to a geometry of the housing. In other words, the cover imitates the outer shape of the housing. In other words, the cover fits closely to the outside surface of the housing of the electronic control device. This is advantageous in that the cover does not unnecessarily increase the assembly space, which is needed for the housing of the electronic control device.

Preferably, the cover is screwed to the housing. The cover may comprise metal inserts, wherein a respective metal insert provides a screw thread for a screw for screwing the cover to the housing. Like this, the relatively weak plastic material is safeguarded from being damaged by the screws. The cover can also be fixed to the housing in any other applicable way, for example by gluing or clipping it to the outer housing surface. The cover may also be slipped onto the housing.

According to a further embodiment, a sealing material is arranged between an inside surface of the cover and the outside surface of the housing, wherein the sealing material is preferably arranged between ribs extending from the inside surface of the cover, which is a surface of the cover, which, in the assembled state, faces the outside surface of the housing. Preferably, the sealing material comprises a glue, which may be cured. In the cured state, the glue may be hard and may not only seal the cover to the housing, but may also add mechanical stability to the mechanical connection between the housing and the cover.

Preferably, the sealing material is spread in a curved bead, wherein in the assembled state the curved bead is squeezed between the outside surface of the housing and the inside surface of the cover. Like this, the contacting surface between the sealing material and the outside surface of the housing, on one hand, and the inside surface of the cover, on the other hand, is increased. This further enhances the mechanical stability of the mechanical connection between the housing and the cover.

Preferably, the cover is non-destructively removable from the outside surface of the housing. It may be unscrewed from the housing and taken off. When taking the cover off, remains of the sealing material may remain on the outer surface of the housing and/or on the inner surface of the cover. The remains may be scratched of or removed otherwise, before the cover may be reused.

According to a further embodiment, the housing comprises fins, which extend outwardly from the outside surface of the housing. The fins may be part of a heat dissipating structure for removing heat from the housing towards an environment of the housing. The housing may take up the heat from the at least one electronic component. By the fins, the electronic component may be more efficiently cooled. As fins of the described type often are arranged largely parallel to each other, they have a tendency to direct water, dust or the like towards one side of the housing. Unfortunately, this side may be the side of the housing with the connecting interfaces. According to the described embodiment, the cover is adapted to prevent water and/or dust directed by the fins towards the connecting interfaces from entering the connecting interfaces.

As stated, the cover preferably comprises a base plate, which may be rectangular, and a rim, wherein the rim extends in the form of rim portions at an angle from the base plate. The base plate and the rim may form two plates, which extend at an angle from each other. The angle may preferably be 90 degrees. The angle may also be adapted to an outer shape of the housing. If the housing comprises an upper housing part or lid with a lid plate and an upper housing rim extending at an angle from the lid plate, the angle between the base plate of the cover and the rim of the cover may imitate this angle. Preferably, the base plate is fastened to the outside surface of the housing lid plate, and the rim is designed to overlap or cover sides of the housing, while leaving free or accessible the connecting interfaces, which are arranged within the upper housing rim.

Preferably, the rim may extend from the base plate at at least three sides of the base plate. In other words, the cover may comprise at least three rim sections. In other words, the cover may comprise at least three rim portions, which may extend at an angle, preferably at an angle of about 90 degrees, from the base plate. Preferably, the cover may be fastened to the outside surface of the housing with its base plate, such that the base plate is fixed with respect to the housing, while the rim portions only partially overlap the side portions of the housing, in particular maintaining accessibility of the connecting interfaces.

According to an alternative embodiment, the rim may extend from the base plate at at least three sides of the base plate. In other words, the cover may comprise at least three rim sections, which in particular may be lifted from the outside surface of the housing individually or collectively. In other words, the cover may comprise at least three rim portions, which may extend at an angle, preferably at an angle of about 90 degrees, from the base plate. Preferably, the cover may be fastened to the outside surface of the housing with its base plate, such that the base plate is fixed with respect to the housing, while the rim portions are movable with respect to the housing. One or more of the rim portions can preferably be lifted up in order to access the connecting interfaces.

Preferably, the electronic device is a control device for controlling at least one vehicle function of the motor vehicle, in particular an electronic control unit (ECU), which can preferably be used for motor vehicles.

In particular, a vehicle-centric, zone-oriented architecture of the electrical or electronic components of the motor vehicle can be provided for the motor vehicle. In particular, at least one main controller, for example a single main controller, can be provided in such a vehicle architecture, which can also be referred to as the main control unit or vehicle computer, and which can be designed to perform the main computing operations for vehicle-specific applications, for example autonomous driving.

The main controller may be connected to several, preferably four, zonal controllers, which may also be referred to as zone controllers, by means of signaling technology. Zonal controllers can be designed to perform less demanding computing operations compared to the main computing operations of the main controller.

For example, the electronic vehicle architecture can be divided into zones, preferably four zones, wherein a zonal controller can be provided for each zone. In particular, the main controller can be connected via the zonal controllers to other electrical and electronic components of the motor vehicle, in particular to smaller, distributed control units, as well as to a large number of sensors and actuators of the motor vehicle.

Such a vehicle-centric, zone-oriented architecture of the electrical or electronic components can be advantageous at least to the extent that they are less complex than domain-oriented architectures. In particular, the computing operations of the complex, vehicle-specific applications of distributed control units can be consolidated on a single or on a few, very powerful main controllers.

Preferably, the electronic assembly according to the invention can be a main controller of the motor vehicle. Alternatively, the electronic assembly according to the invention may be a zonal controller of the motor vehicle. Accordingly, the cooling device according to the invention can be provided for cooling the powerful electronic components of a main controller or a zonal controller.

The electronic component may in particular be a component of the ECU, in particular a SoC, a microchip, a processor, an integrated circuit or the like, wherein the powerful electronic component generates harmful waste heat during operation, which must be dissipated by means of the cooling device.

A further aspect of the invention relates to a motor vehicle comprising an electronic device according to the invention.

Further embodiments of the motor vehicle according to the invention follow directly from the various embodiments of the electronic control device according to the invention and vice versa. In particular, individual features and corresponding explanations as well as advantages relating to the various implementations of the electronic control device according to the invention can be transferred analogously to implementations of the motor vehicle according to the invention and vice versa.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, may also be comprised by the invention. Moreover, embodiments and combinations of features, which go beyond or deviate from the combinations of features set forth in the recitations of the claims may be comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

Embodiments of the invention are described below. In the figures:
- Fig.1: Shows a schematic top view of an electronic control device according to an embodiment of the invention, and an enlarged detailed view of the device;
- Fig. 2: Shows a schematic exploded view of an upper housing part of an electronic control device according to an embodiment of the invention with a cover and fastening screws;
- Fig. 3: Shows a schematic oblique view of the parts of Fig. 2 in an assembled state, wherein connecting interfaces of the electronic component are shielded from dust or droplets of water from the top and remain accessible from the front;
- Fig. 4: Shows a schematic detailed view of a cover with metal inserts and two beads of sealing material according to an embodiment of the invention;
- Fig. 5a: Shows a schematic cross sectional view of the electronic control device with the cover according to an embodiment of the invention;
- Fig. 5b: Shows a schematic cross sectional view of the electronic control device with the cover according to a further embodiment of the invention; and
- Fig. 6: Shows a schematic view of a motor vehicle with an electronic device according to an embodiment of the invention.

The embodiments explained below are preferred embodiments of the invention. In the embodiments, the described components of the embodiments each represent individual features of the invention which are to be considered independently of each other, which also further form the invention independently of each other and are thus also to be regarded as part of the invention individually or in a combination other than that shown. Furthermore, the embodiment described can also be supplemented by other features of the invention already described.

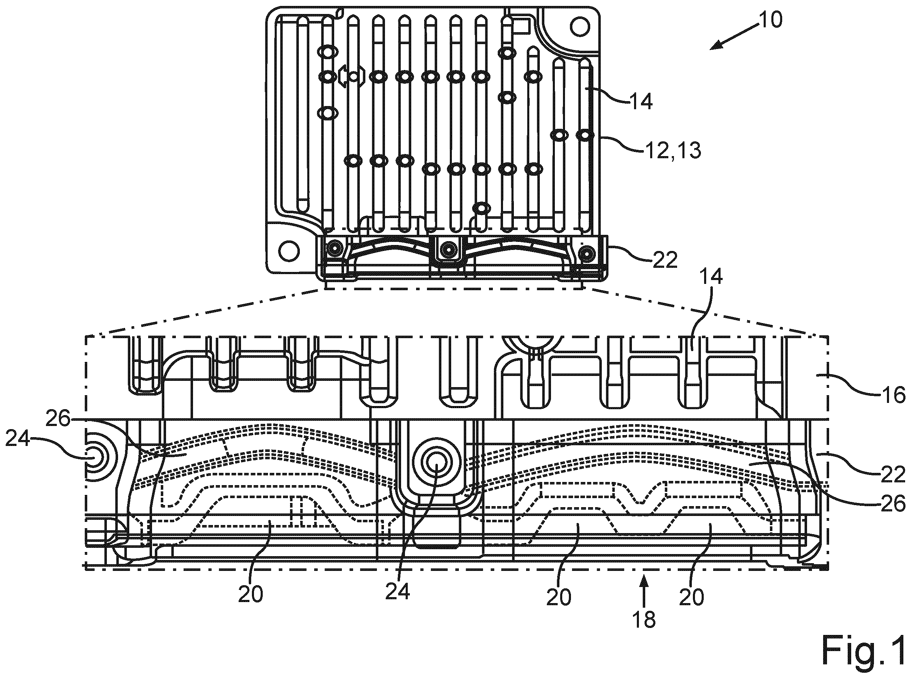

Fig. 1 shows a schematic top view of an electronic control device 10 according to an embodiment of the invention, and an enlarged detailed view of the electronic control device 10 in the lower part of the figure.

The electronic control device 10 according to the embodiment shown in Fig. 1 comprises a housing 12 with a plurality of fins 14 extending from an outer surface 16 of the housing. The housing 12 may be cast from aluminum. The housing 12 may be formed integrally with the fins 14. As an alternative, the fins 14 may be welded to the outer surface 16 of the housing 12. The fins 14 may act as heat dissipating elements for dissipating heat from the electronic components within the housing 12 towards an environment of the housing 12.

Fig. 1 shows only an upper housing part 13 or a housing lid. The lower housing part is not shown for reasons of readability of the figure.

On a front side 18 of the housing 12, the housing 12 comprises several connecting interfaces 20 for connecting the electronic components inside the housing 12 to an on-board network of the motor vehicle (not shown). In other words, the electronic components can be electrically connected to the vehicle electronic network through the housing 12 via the connecting interfaces 20. The connecting interfaces 20 can be electrically connected to the electronic components inside the housing 12 on one hand and to the vehicle electronic network outside the housing 12 on the other hand.

In order to prevent water and/or dust and/or any other kind of contamination to enter the connecting interfaces 20, the housing 12 comprises a cover 22, which is fastened with screws 24 to the housing 12. In order to improve the sealing properties of the cover 22, additional sealing material 26 in the form of two beads of sealing material 26 is applied between the outer housing surface 16 and an inner surface of the cover 22, which in the assembled state of Fig. 1 faces the outer housing surface 16.

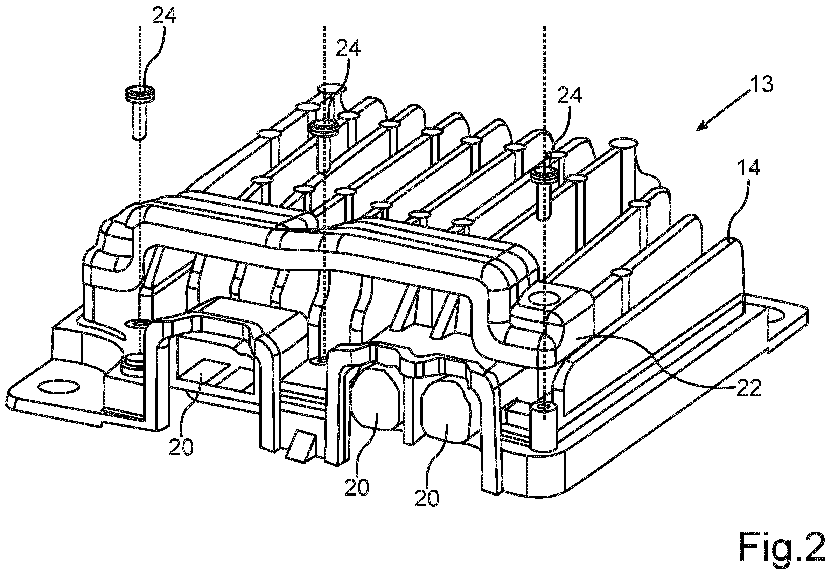

Fig. 2 shows a schematic exploded view of an upper housing part 13 of an electronic control device 10 according to an embodiment of the invention with a cover 22 and fastening screws 24. As can be seen from Fig. 2, the cover 22 may be placed on top of the upper housing part 13, wherein it is adapted in its shape to the outer geometry of parts of the upper housing part 13. In particular, the cover 22 is adapted to the outer geometry of the upper housing part 13 such that it does not add up to the assembly space needed for the housing 12.

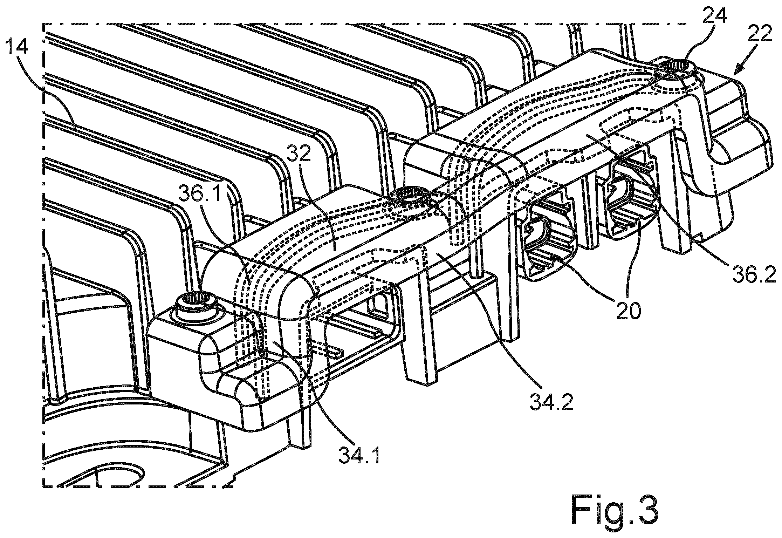

In an assembled state, the cover 22 at least partially covers the connecting interfaces 20 and shields them from water droplets or dust, which might be directed towards the connecting interfaces 20 by the geometry of the fins 14, which may form channels directed towards the connecting interfaces 20. As can be seen from Fig. 3, the connecting interfaces 20 remain accessible from the front.

Fig. 3 shows the base plate 32 and rim portions 34.1 and 34.2, which extend in an angle of about 90 degrees from the base plate 32. Rim portion 34.1 is connected to the base plate by bending portion 36.1, and rim portion 34.2 is connected to the base plate by bending portion 36.2, respectively. Rim portion 34.2 partially overlaps the side of the housing 12, which comprises the connecting interfaces 20, while accessibility of the connecting interfaces 20 is maintained, preferably at all times.

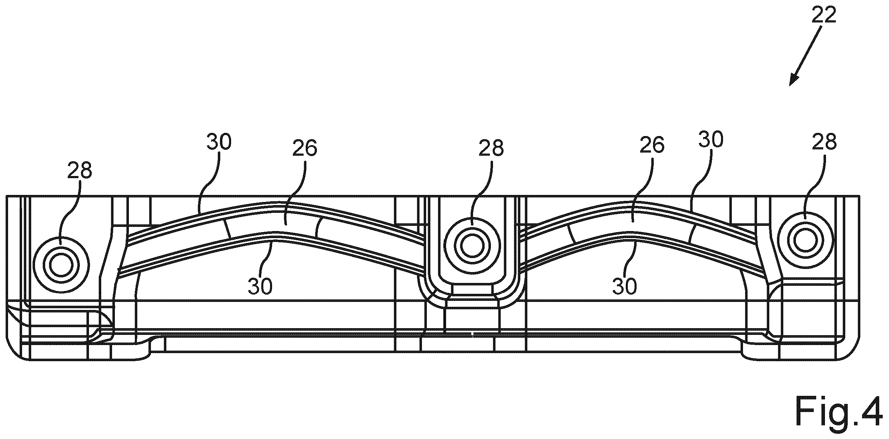

Fig. 4 shows a schematic detailed view of a cover 22 with metal inserts 28 and two beads of sealing material 26 (e-sealing) according to an embodiment of the invention. Each of the metal inserts 28 may comprise along its inner circumferential surface a screw thread for a screw 24. The metal screw threads may safeguard or protect the plastic material of the cover 22 from damage from the screws 24.

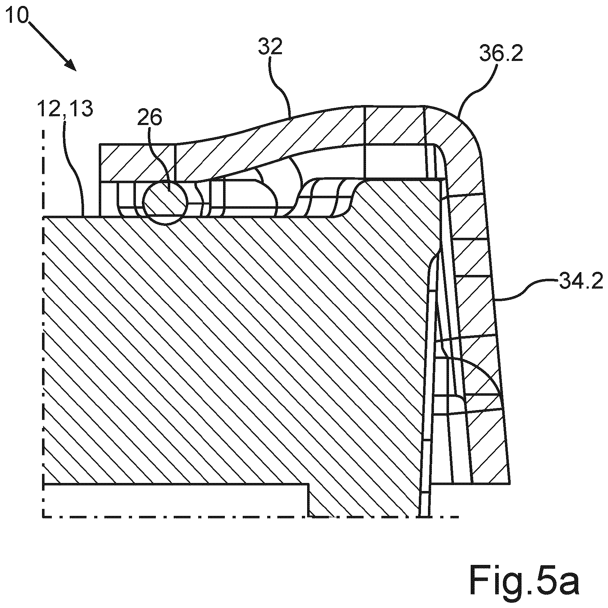

Each of the beads of sealing material 26 may be confined by a pair of ribs 30, which may provide a bed for a respective bead of sealing material 26. The ribs 30 may help in accurately applying the beads of sealing material 26. They may also keep the sealing material 26 in place before curing, i.e. before it is hardened. The cover 22 with the ribs 30 may be manufactured as one piece in a single injection molding manufacturing step. Fig. 5a shows a schematic cross sectional view of the electronic control device 10 with the cover 22 according to an embodiment of the invention. The cover 22 may comprise a base plate 32 and a rim portion 34.2, which extends at an angle from the base plate 32.

The cover 22 may comprise a bending portion 36.2, which connects the base plate 32 and the rim portion 34.2. According to an embodiment, the rim portion 34.2 may be lifted up from covering the connecting interfaces by bending the cover 22 along the bending portion 36.2 for accessing the connecting interfaces (not shown) in an upward direction.

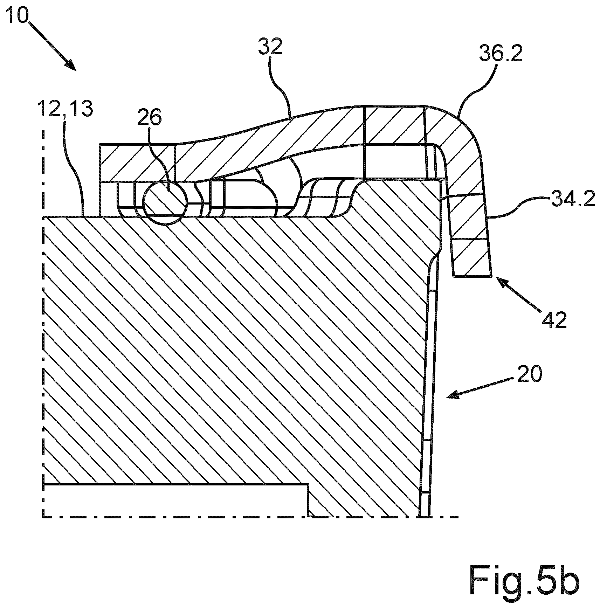

Fig. 5b shows a schematic cross sectional view of the electronic control device 10 with the cover 22 according to a further embodiment. Here, rim portion 34.2 is shorter than in the embodiment shown in Fig. 5a. Thus, rim portion 34.2 does not cover the connecting interfaces 20. Rather, rim portion 34.2 provides at its free end 42, which is the end of the rim portion 34.2 opposite the bending portion 36.2, a drip edge for water droplets, which are prevented from entering the connecting interfaces 20. Like this, the connecting interfaces 20 are reliably protected from any contamination and accessible at all times.

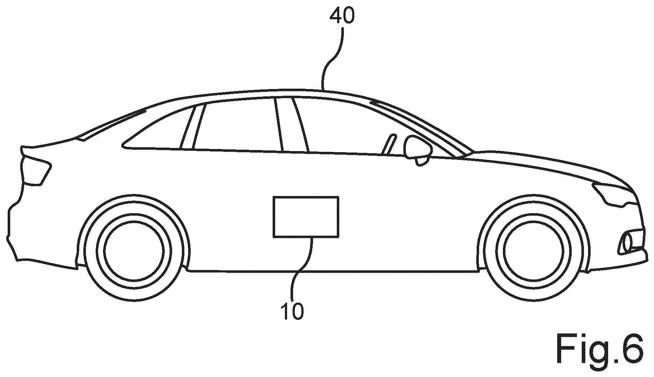

Fig. 6 shows a schematic view of a motor vehicle 40 with an electronic control device 10 according to an embodiment of the invention.

Typically, water entry can be controlled through a shroud on the upper housing at certain angles or mounting orientations of the electronic control device housing in the motor vehicle. However, under specific mounting conditions and connector visibility requirements, it may fail to meet the purpose.

The present invention offers:
Unrestricted mounting direction, allowing mounting angles from +90 to -90 degrees, the elimination of the complex shroud design, enhanced connector visibility by using transparent PC clear material for the cover, allowing a clear view of the connectors or connecting interfaces, and the cover is transparent to facilitate visual inspection during the assembly line process.

Overall, the examples show, how an electronic control device for a motor vehicle with a housing, which prevents water entry into the housing, while providing maximum flexibility as regards mounting orientation of the housing in the motor vehicle can be provided.

## Claims

1. Electronic control device (10) for a motor vehicle (40), comprising at least one electronic component and a housing (12), wherein the electronic component is arranged inside the housing (12), wherein connecting interfaces (20) for connecting the at least one electronic component to a vehicle electronic network are arranged along a side of the housing (12), which faces an environment of the housing (12), **characterized by**
a cover (22) arranged on an outside surface (16) of the housing (12), wherein in an assembled state, the cover (22) at least partially overlaps at least the side of the housing (12), which comprises the connecting interfaces (20) for connecting the at least one electronic component to the vehicle electronic network, while maintaining the accessibility of the connecting interfaces (20).

2. Electronic control device (10) according to claim 1, wherein the cover (22) is at least partially made from a transparent material, preferably a transparent plastic material.

3. Electronic control device (10) according to any of the preceding claims, wherein the cover (22) comprises a bending portion (36.1, 36.2), wherein the bending portion (36.1, 36.2) connects a base plate (32) of the cover (22) to a rim portion (34.1, 34.2) of the cover (22).

4. Electronic control device (10) according to claim 3, wherein the base plate (32) of the cover (22) at least partially covers a top portion of the electronic component housing (12), and the rim portion (34.1, 34.2) of the cover (22) at least partially overlaps side portions of the electronic component housing (12), while maintaining the accessibility of the connecting interfaces (20).

5. Electronic control device (10) according to any of the preceding claims, wherein the shape of the cover (22) is adapted to a geometry of the housing (12).

6. Electronic control device (10) according to any of the preceding claims, wherein the cover (22) is screwed to the housing (12).

7. Electronic control device (10) according to claim 6, wherein the cover (22) comprises metal inserts (28), wherein a respective metal insert (28) provides a screw thread for a screw (24) for screwing the cover (22) to the housing (12).

8. Electronic control device (10) according to any of the preceding claims, wherein a sealing material (26) is arranged between the cover (22) and the outside surface (16) of the housing (12), wherein the sealing material (26) is preferably arranged between ribs (30) extending from a surface of the cover (22), which, in the assembled state, faces the outside surface (16) of the housing (12).

9. Electronic control device (10) according to claim 6, wherein the sealing material (26) comprises a glue.

10. Electronic control device (10) according to any of claims 8 or 9, wherein the sealing material (26) is spread in a curved bead, wherein in the assembled state the curved bead is squeezed between the outside surface (16) of the housing (12) and the cover (22).

11. Electronic control device (10) according to any of the preceding claims, wherein the cover (22) is non-destructively removable from the outside surface (16) of the housing (12).

12. Electronic control device (10) according to any of the preceding claims, wherein the housing (12) comprises fins (14), which extend outwardly from the outside surface (16) of the housing (12), wherein the cover (22) is adapted to prevent water and/or dust directed by the fins (14) towards the connecting interfaces (20) from entering the connecting interfaces (20).

13. Electronic control device (10) according to any of claims 3 to 12, wherein the cover (22) comprises the base plate (32) and the rim portion (34.1, 34.2), wherein the rim portion (34.1, 34.2) extends in the form of at least one rim portion (34.1, 34.2) at an angle from the base plate (32) at at least one side of the base plate (32), preferably in the form of at least three rim portions (34.1, 34.2), which extend at an angle from the base plate (32) at at least three sides of the base plate (32), wherein the base plate (32) is fastened to the outside surface (16) of the housing (12) of the electronic device (10), and wherein the at least one rim portion (34.1, 34.2), preferably the at least three rim portions (34.1, 34.2), are designed to at least partially cover sides of the housing (12), while maintaining the accessibility of the connecting interfaces (20).

14. Electronic control device (10) according to any of the preceding claims, wherein the electronic control device (10) is a control device of the motor vehicle (40), which is designed to control at least one vehicle function of the motor vehicle (40).

15. Motor vehicle (40) with an electronic control device (10) according to any of the preceding claims.
